Europäisches Patentamt

European Patent Office

Office européen des brevets

(11) Veröffentlichungsnummer: **0 440 079 A2**

(19)
(12)

# EUROPÄISCHE PATENTANMELDUNG

(21) Anmeldenummer: 91100794.6

(22) Anmeldetag: 23.01.91

(51) Int. Cl.5: **G03F 7/18, B41C 1/18**

(30) Priorität: 02.02.90 DE 4003093

(43) Veröffentlichungstag der Anmeldung:
07.08.91 Patentblatt 91/32

(84) Benannte Vertragsstaaten:
**DE FR GB IT**

(71) Anmelder: **BASF Aktiengesellschaft**
**Carl-Bosch-Strasse 38**
**W-6700 Ludwigshafen(DE)**

(72) Erfinder: **Zuerger, Manfred**
**Holderlandstrasse 2**
**W-6920 Sinsheim(DE)**
Erfinder: **Bleckmann, Gerhard**
**Giselherstrasse 9**
**W-6840 Lampertheim 5(DE)**
Erfinder: **Bueschges, Eleonore, Dr.**
**Schauinslandstrasse 9**
**W-6800 Mannheim 1(DE)**
Erfinder: **Bauer, Gerhard, Dr.**
**Friedrich-Fosler-Strasse 4**
**W-6940 Weinheim(DE)**

(54) **Verfahren zur Herstellung einer endlosen, lichtempfindlichen polymeren Aufzeichnungsschicht für die Herstellung von Endlos-Druckformen.**

(57) Die Erfindung betrifft ein Verfahren zur Herstellung einer endlosen, festen, lichtempfindlichen polymeren Aufzeichnungsschicht auf einer zylinderförmigen Oberfläche für die Herstellung von Endlos-Druckformen, bei dem die die Aufzeichnungsschicht bildende lichtempfindliche polymere Aufzeichnungsmasse in fließfähiger Form unter Ausbildung einer endlosen Schicht auf die zylinderförmige Oberfläche aufgebracht und darauf verfestigt wird, wobei man der Oberfläche der endlosen, lichtempfindlichen polymeren Aufzeichnungsschicht während der Schichtverfestigung durch Walzenbehandlung eine definierte Oberflächenstruktur gibt. Aus den so hergestellten festen, endlosen, lichtempfindlichen polymeren Aufzeichnungsschichten lassen sich Endlos-Druckformen mit sehr guten reproduktionstechnischen Eigenschaften herstellen.

EP 0 440 079 A2

# VERFAHREN ZUR HERSTELLUNG EINER ENDLOSEN, LICHTEMPFINDLICHEN POLYMEREN AUFZEICH-NUNGSSCHICHT FÜR DIE HERSTELLUNG VON ENDLOS-DRUCKFORMEN

Die Erfindung betrifft ein Verfahren zur Herstellung einer endlosen, festen, lichtempfindlichen polymeren Aufzeichnungsschicht auf einer zylinderförmigen Oberfläche für die Herstellung von Endlos-Druckformen, bei dem die die endlose Aufzeichnungsschicht bildende lichtempfindliche polymere Aufzeichnungsmasse in fließfähiger Form auf die zylinderförmige Oberfläche aufgebracht und darauf verfestigt wird. Die Erfindung betrifft des weiteren ein Verfahren zur Herstellung von Endlos-Druckformen mittels der erfindungsgemäß hergestellten endlosen, festen, lichtempfindlichen polymeren Aufzeichnungsschicht.

Der Einsatz von photopolymeren Druckplatten im Hochdruck, einschließlich Flexodruck, im Offsetdruck und auch im Tiefdruck ist wohlbekannt und weit verbreitet. Zum Drucken wird dabei die photopolymere Druckplatte im allgemeinen auf einen Formzylinder aufgebracht. Da hierbei zwischen den Enden der um den Formzylinder gewickelten Druckplatte ein mehr oder weniger ausgeprägter Spalt verbleibt, eignet sich diese Methode nicht für die Herstellung von fortlaufenden Druckmustern, die keine Unterbrechungen aufweisen, sogenannten "Endlosdrucken". Um die heute gebräuchlichen, vorteilhaften, lichtempfindlichen polymeren Druckplatten-Materialien auch für die Herstellung von Endlos-Druckformen mit einem fortlaufenden, nicht unterbrochenen Druckmuster nutzen zu können, hat es nicht an Vorschlägen gefehlt, Formzylinder oder Formzylinder-Hülsen (sogenannte "sleeves") mit einer durchgehenden, nahtlosen, lichtempfindlichen polymeren Aufzeichnungsschicht zu beschichten.

So werden in der DE-A-27 22 896, DE-A-28 44 426, DE-A-28 42 440 und DE-A-29 11 908 zu diesem Zweck beispielsweise Verfahren zur Kantenverbindung lichthärtbarer, thermoplastisch verarbeitbarer Druckplatten beschrieben. Bei diesen Verfahren wird ein Formzylinder oder eine Formzylinder-Hülse mit einer vorgefertigten, festen, thermoplastisch verarbeitbaren lichtempfindlichen Schicht umwickelt, wobei nach der Umwicklung die aneinanderstoßenden Kanten der Endabschnitte der lichtempfindlichen Schicht unter dem Einfluß von Wärme und Druck durch Verschweißen miteinander verbunden werden. Diese Verfahrensweise hat neben dem Erfordernis des genauen Zuschnitts der lichtempfindlichen Schicht auf den Umfang der zu beschichtenden Formzylinder bzw. Formzylinder-Hülsen den weiteren Nachteil, daß die ausgebildete Schweißnaht häufig nur relativ schwach und mechanisch wenig beanspruchbar ist, so daß die im allgemeinen notwendige formgebende mechanische Nachbehandlung der verschweißten lichtempfindlichen Schicht nur schlecht oder gar nicht möglich ist. Bei den in der EP-A-280 103 und der EP-A-280 922 beschriebenen Verfahren zum Beschichten von Formzylindern oder Formzylinder-Hülsen mit einer durchgehenden, nahtlosen lichtempfindlichen Aufzeichnungsschicht zur Herstellung von Endlos-Druckformen geht man ebenfalls von vorgefertigten, festen, thermoplastisch verarbeitbaren, lichtempfindlichen Aufzeichnungsschichten aus, die in mehreren Lagen auf einer zylindrischen Oberfläche aufgebracht werden, wonach man die einzelnen Lagen miteinander verschmilzt. Auch die in der EP-A-280 103 und EP-A-280 922 beschriebenen Verfahren machen eine mechanische, materialabtragende Nachbehandlung der Oberfläche der erhaltenen endlosen lichtempfindlichen Schicht notwendig.

Ferner ist es bekannt, zur Herstellung von endlosen, lichtempfindlichen polymeren Aufzeichnungsschichten für die Herstellung von Endlos-Druckformen Formzylinder mit einer Lösung der lichtempfindlichen polymeren Aufzeichnungsmasse zu beschichten und die Schicht dann durch Verdampfen des Lösungsmittels zu verfestigen. Das Beschichten des Formzylinders mit der Lösung der lichtempfindlichen polymeren Aufzeichnungsmasse kann dabei, wie beispielsweise der DE-A-26 40 105 zu entnehmen ist, nach verschiedenen Methoden, beispielsweise durch Spritzen, Tauchen, Gießen, mittels Auftragswalzen oder Extrusion, erfolgen. Die Lösungsbeschichtung ist nicht, wie die Verfahren, die von einer vorgefertigten, festen, lichtempfindlichen polymeren Aufzeichnungsschicht ausgehen, an eine lichtempfindliche, thermoplastisch verarbeitbare Aufzeichnungsmasse gebunden und ist somit breiter anwendbar. Auch bei den nach den Verfahrensmethoden der Lösungs-Beschichtung hergestellten endlosen, lichtempfindlichen polymeren Aufzeichnungsschichten kann eine Nachbearbeitung dieser Schichten erforderlich sein. Eine solche Nachbearbeitung erfolgt nach der Lehre der DE-A-26 40 105 zur Verbesserung der Präzision des Zylinders nach der Trocknung und damit nach der Verfestigung der Schicht und ist materialabtragend.

Für die Qualität der Druckerzeugnisse sind neben den mechanischen und physikalisch-chemischen Eigenschaften der Druckschicht auch das Farbannahme-und Farbübertragungsverhalten der Druckform von entscheidender Bedeutung, welche von der Oberflächenstruktur der Druckform mitbestimmt werden. Eine mechanische materialabtragende Bearbeitung, wie sie für die bekannten Verfahren zur Herstellung von endlosen, festen, lichtempfindlichen polymeren Aufzeichnungsschichten für die Herstellung von Endlosdruckformen erforderlich ist und beschrieben wird, ist nicht nur aufwendig; eine gezielte, definierte und reproduzierbare Einstellung des Einfärb- und Farbübertragungsverhaltens der Endlos-Druckschichten ist hierbei nicht oder nur sehr begrenzt möglich.

Aufgabe der vorliegenden Erfindung war es, ein möglichst einfaches und vielseitig anwendbares Verfahren zur Herstellung von endlosen, festen, lichtempfindlichen polymeren Aufzeichnungsschichten aufzuzeigen, wobei sich die erhaltenen, endlosen, lichtempfindlichen Aufzeichnungsschichten mit Vorteil für die Herstellung von Endlos-Druckformen eignen sollen. Aufgabe der Erfindung war weiterhin die Schaffung eines solchen Verfahrens der vorstehenden Art bzw. eines entsprechenden Verfahrens zur Herstellung von Endlos-Druckformen, mit dem es möglich ist, in einfacher, gezielter und reproduzierbarer Weise das Einfärbeverhalten bzw. Farbübertragungsverhalten der Endlos-Druckformen einzustellen und zu steuern.

Diese Aufgaben werden erfindungsgemäß durch ein Verfahren der eingangs erwähnten Art gelöst, bei dem man eine zylinderförmige Oberfläche mit einer fließfähigen, lichtempfindlichen polymeren Aufzeichnungsmasse endlos beschichtet, die so erzeugte endlose, lichtempfindliche polymere Aufzeichnungsschicht verfestigt und der Aufzeichnungsschicht während der Schichtverfestigung durch Walzenbehandlung eine definierte Oberflächenstruktur gibt.

Gegenstand der Erfindung ist dementsprechend ein Verfahren zur Herstellung einer endlosen, festen, lichtempfindlichen polymeren Aufzeichnungsschicht auf einer zylinderförmigen Oberfläche für die Herstellung von Endlos-Druckformen, bei dem die die Aufzeichnungsschicht bildende lichtempfindliche polymere Aufzeichnungsmasse in fließfähiger Form endlos auf die zylinderförmige Oberfläche aufgebracht und darauf verfestigt wird. Das Verfahren ist dadurch gekennzeichnet, daß man der Oberfläche der endlosen, lichtempfindlichen polymeren Aufzeichnungsschicht während der Schichtverfestigung durch Walzenbehandlung eine definierte Oberflächenstruktur gibt.

Gegenstand der Erfindung ist weiterhin ein Verfahren zur Herstellung von Endlos-Druckformen, bei dem man eine zylinderförmige Oberfläche mit einer fließfähigen, lichtempfindlichen polymeren Aufzeichnungsmasse endlos beschichtet, die so erzeugte endlose, lichtempfindliche polymere Aufzeichnungsschicht verfestigt, darauf bildmäßig mit aktinischem Licht belichtet und unter Entfernen, z.B. Auswaschen mit einem Entwicklerlösungsmittel, der unbelichteten bzw. belichteten Bereiche der Aufzeichnungsschicht entwickelt. Das Verfahren ist dadurch gekennzeichnet, daß man der Oberfläche der endlosen, lichtempfindlichen polymeren Aufzeichnungsschicht während der Schichtverfestigung durch Walzenbehandlung eine definierte Oberflächenstruktur gibt.

Gegenstand der Erfindung sind weiterhin spezielle Ausführungsformen der vorstehend genannten Verfahren gemäß der nachfolgenden detaillierten Beschreibung der Erfindung.

Mit den erfindungsgemäßen Verfahren lassen sich in einfacher, gezielter und gut reproduzierbarer Weise polymere Endlos-Druckschichten mit gleichbleibendem, streng reproduzierbarem Einfärb- und Farbübertragungsverhalten durch Aufprägen einer bestimmten, definierten Oberflächenstruktur herstellen, und zwar gleichermaßen für den Tiefdruck als auch für den Hochdruck, einschließlich Flexodruck. Erfindungsgemäß lassen sich nicht nur verschiedene Oberflächenrauhigkeiten einstellen, sondern es lassen sich beispielsweise auch endlose, lichtempfindliche polymere Aufzeichnungsschichten mit sehr glatter Oberfläche herstellen, wie sie üblicherweise für den Tiefdruck benötigt werden, selbst wenn die für die Herstellung der Aufzeichnungsschicht eingesetzten lichtempfindlichen polymeren Aufzeichnungsmassen abrasive Füllstoffe zur Erhöhung der Kratz- und Abriebfestigkeit enthalten. Eine nachträgliche mechanische, materialabtragende Oberflächenbehandlung, wie sie bei den bekannten Verfahren zur Herstellung von endlosen, lichtempfindlichen polymeren Aufzeichnungsschichten zum Erhalt einer toleranzgenauen zylindrischen Oberfläche hoher Präzision erforderlich ist, ist bei den erfindungsgemäßen Verfahren nicht vonnöten. Erfindungsgemäß läßt sich nicht nur die Oberflächenrauhigkeit der endlosen, lichtempfindlichen polymeren Aufzeichnungsschichten und dadurch auch der hieraus hergestellten endlosen Druckformen problemlos beliebig und reproduzierbar einstellen, sondern kann man den Oberflächen auch andere Strukturen, wie z.B. Linien- oder Rastermuster, aufprägen, was insbesondere auch für die Herstellung von Tiefdruckformen von Interesse ist. Überraschenderweise hat sich gezeigt, daß hierbei auch feine Oberflächenmuster und -strukturen definiert und reproduzierbar erzeugt werden können, obwohl die Walzenbehandlung erfindungsgemäß während der Verfestigung der lichtempfindlichen polymeren Aufzeichnungsschicht vorgenommen wird.

Es sind wohl schon Verfahren bekannt, um lichtempfindliche Druckplatten mit einer ungleichmäßigen oder gekörnten Oberfläche zu versehen. So wird zu diesem Zweck beispielsweise in der DE-A-25 33 156 ein Verfahren beschrieben, bei dem man die obere Schicht einer lichtempfindlichen Druckplatte unter Verwendung einer Walze mit unebener bzw. ungleichmäßiger Oberfläche aufbringt. Abgesehen davon, daß in dieser Druckschrift nur die Herstellung von Druckplatten, nicht aber die von Endlos-Druckformen angesprochen ist, soll mit diesem Verfahren eine matte Schicht hergestellt werden, durch die das Auflegen der Bildvorlage bei der Belichtung der lichtempfindlichen Druckplatte erleichtert und verbessert wird. Das in der DE-A-25 33 156 beschriebene Verfahren zur Erzeugung einer matten Oberfläche durch Aufbringen der letzten Schicht mittels einer Walze mit unebener bzw. ungleichmäßiger Oberfläche eignet sich nicht für den erfindungsgemäßen Zweck, nämlich die Herstellung reproduzierbarer, definierter Oberflächenstrukturen, einschließlich sehr glatter Oberflächen, bei endlosen, lichtempfindlichen polymeren Aufzeichnungsschichten zur Steuerung des Einfärb- und Farbübertragungsverhaltens. Auch in der DE-A-24 03 487 wird die Herstellung lichtempfindlicher Druckplatten mit einer mattierten oder gekörnten Oberfläche beschrieben. Gemäß der Lehre der DE-A-24 03 487 wird hierzu der lichtempfindlichen Aufzeichnungsschicht der Druckplatte die Konfiguration einer mattierten oder gekörnten Oberfläche eines anderen Materials, beispielsweise einer mattierten oder gekörnten Platte oder Kunststoff-Folie, erteilt. Das Überführen der Konfiguration der mattierten oder gekörnten Oberfläche des anderen Materials auf die lichtempfindliche Aufzeichnungsschicht soll dabei entweder mittels Druck und/oder Wärme oder durch Lösungsmittelbeschichtung des lichtempfindlichen Materials auf die mattierte oder gekörnte Oberfläche des anderen Materials erfolgen. Auch in der DE-A-24 03 487 wird nicht die Herstellung von endlosen, lichtempfindlichen polymeren Aufzeichnungsschichten auf einer zylinderförmigen Oberfläche angesprochen. Die in der DE-A-24 03 487 beschriebenen Verfahrensweisen zur Mattierung bzw. Körnung der Oberfläche lassen sich nicht bei der Herstellung von Endlos-Schichten anwenden. Die Mattierung bzw. Körnung der Oberfläche der lichtempfindlichen Druckplatten gemäß der DE-A-24 03 487 dient dabei auch einem anderen Zweck, nämlich einem erleichterten und verbesserten Auflegen der Bildvorlage bei der bildmäßigen Belichtung der lichtempfindlichen Druckplatte. Demgegenüber ist es erfindungsgemäßes Ziel, den endlosen, lichtempfindlichen polymeren Aufzeichnungsschichten gezielt eine solche definierte, reproduzierbare Oberflächenstruktur zu geben, durch die das Einfärbverhalten der Druckformen bzw. deren Farbübertragungsverhalten auf den Bedruckstoff verbessert und optimal gesteuert werden kann. Weder der DE-A-25 33 156 noch der DE-A-24 03 487 kann ein Hinweis entnommen werden, zur Lösung dieser Aufgabe die erfindungsgemäße Verfahrensweise einzusetzen.

Erfindungsgemäß wird die die endlose ,feste Aufzeichnungsschicht bildende lichtempfindliche polymere Aufzeichnungsmasse in fließfähiger Form auf eine zylinderförmige Oberfläche aufgebracht. Als zylinderförmige Oberfläche dienen dabei insbesondere die Oberflächen von für die Herstellung von Rotationsdruckformen üblichen und gebräuchlichen Formzylindern bzw. Formzylinder-Hülsen. Während die Formzylinder üblicherweise aus Metall, wie beispielsweise Eisen, Stahl, Aluminium oder Kupfer bestehen, können die Formzylinder-Hülsen außer aus Metall auch aus Kunststoffen, glasfaserverstärkten Kunststoffen oder dgl. gebildet sein. Die Oberfläche der Formzylinder bzw. Formzylinder-Hülsen, auf die die endlose, lichtempfindliche polymere Aufzeichnungsschicht aufgebracht wird, kann glatt oder rauh bzw. strukturiert sein, um beispielsweise eine bessere Haftung zu der lichtempfindlichen polymeren Aufzeichnungsschicht zu erzielen. Aus gleichem Grund kann die Oberfläche der Formzylinder bzw. Formzylinder-Hülsen auch beispielsweise chemisch oder elektrochemisch vorbehandelt oder mit einem Haftlack, einer Haftschicht, einem Klebstoff oder dgl. versehen sein. Als chemische Behandlung für die Oberfläche von Formzylindern bzw. Formzylinder-Hülsen aus Eisen bzw. Stahl eignet sich z.B. eine solche mit Zinkphosphat, bei Formzylindern oder Formzylinder-Hülsen aus Aluminium eine solche mit einer Chromat-Lösung. Als Haftschichten kommen die bekannten und üblichen Haftschichten in Betracht, wie sie bei der Herstellung von ebenen, flachen Druckplatten für die jeweiligen betreffenden lichtempfindlichen polymeren Aufzeichnungsschichten eingesetzt werden, beispielsweise solche aus Polyurethan-Ein- oder -Mehrkomponentensystemen. Bei Verwendung von Formzylindern oder Formzylinder-Hülsen mit stark reflektierenden Oberflächen empfiehlt sich der Einsatz von Lichthofschutzschichten zwischen der zylinderförmigen Oberfläche des Trägers und der lichtempfindlichen polymeren Aufzeichnungsschiht. Hierzu können in an sich bekannter Weise beispielsweise die als Lichthofschutzmittel üblichen und bekannten Farbstoffe oder Pigmente in ggf. vorgesehene Haftschichten eingemischt werden oder diese Farbstoffe bzw. Pigmente enthaltende, eigene Schichten, gegebenenfalls zusätzlich zu den Haftschichten, geformt werden. Ferner können die Formzylinder bzw. Formzylinder-Hülsen auch beispielsweise mit einer Kunststoff- oder Kautschukschicht beschichtet werden, bevor die endlose, feste, lichtempfindliche polymere Aufzeichnungsschicht aufgebracht wird. Diese Kunststoff- oder Kautschukschichten können der Einstellung der drucktechnischen Eigenschaften der Druckformen, beispielsweise beim Flexodruck, dienen. Werden in dem erfindungsgemäßen Verfahren solche, mit einer Kunststoff- oder Kautschukschicht beschichteten Formzylinder oder Formzylinder-Hülsen als Träger für die lichtempfindliche polymere Aufzeichnungsschicht eingesetzt, so ist darauf zu achten, daß die Kunststoff-oder Kautschukschicht aus einem solchen Material gebildet wird, welches bei dem Auftragsprozeß der die Aufzeichnungsschicht bildenden lichtempfindlichen polymeren Aufzeichnungsmasse nicht geschädigt oder beeinträchtigt, beispielsweise gelöst, wird.

Die die endlose, feste Aufzeichnungsschicht bildende lichtempfindliche polymere Aufzeichnungsmasse ist als solche selbstverständlich bei Raumtemperatur fest, wird erfindungsgemäß aber in fließfähiger Form auf die zylindrische Oberfläche aufgebracht. Als fließfähige Form kommt beispielsweise eine Schmelze der lichtempfindlichen polymeren Aufzeichnungsmasse in Betracht, wobei dann die Verfahrensbedingungen, insbesondere die Temperatur, so zu wählen sind, daß hierdurch die lichtempfindliche polymere Aufzeichnungsmasse nicht geschädigt wird. In Abhängigkeit von der jeweils eingesetzten lichtempfindlichen polymeren Aufzeichnungsmasse sind für den Schmelzauftrag im allgemeinen Verarbeitungstemperaturen im Bereich von etwa 100 bis 220° C, insbesondere von etwa 120 bis 200° C, günstig.

Vorzugsweise werden die lichtempfindlichen polymeren Aufzeichnungsmassen erfindungsgemäß jedoch in Form einer Lösung auf die zylinderförmige Oberfläche aufgebracht. Als Lösungsmittel kommen insbesondere leicht verdampfbare in Betracht, die nach dem Auftrag der Beschichtungs-Lösung auf die zylinderförmige Oberfläche beim Trocknen und Verfestigen der Aufzeichnungsschicht problemlos und in angemessener Zeit abgedampft werden können. Die Wahl des Lösungsmittels richtet sich daneben in erster Linie nach der Art der lichtempfindlichen polymeren Aufzeichnungsmasse, die gelöst und aufgebracht werden soll. Als Beispiele geeigneter Lösungsmittel für die Beschichtungslösungen der lichtempfindlichen polymeren Aufzeichnungsmassen seien neben Wasser insbesondere die organischen Lösungsmittel, wie Alkohole, Ester, Ether oder Ketone, genannt. Vorzugsweise und beispielhaft seien als Stellvertreter hierfür u.a. Aceton, Methylethylketon, Tetrahydrofuran, Ethanol und Methanol angeführt. Selbstverständlich können auch Mischungen dieser Lösungsmittel, einschließlich wäßrig-organischer Lösungsmittelgemische, wie Wasser-Alkohol-Gemische, für die Herstellung der Beschichtungslösungen eingesetzt werden.

Der Feststoffgehalt der Beschichtungslösungen, d.h. deren Konzentration, wird in Abhängigkeit von der jeweiligen lichtempfindlichen polymeren Aufzeichnungsmasse so gewählt, daß die rheologischen Eigenschaften der Beschichtungslösung auf das entsprechende Beschichtungsverfahren abgestimmt und diesem angepaßt sind. Gegebenenfalls können zur Einstellung des gewünschten Fließverhaltens auch noch übliche Thixotropierungsmittel mitverwendet werden. Üblicherweise liegt der Feststoffgehalt der Beschichtungslösungen im Bereich von 5 bis 50 Gew.-%, insbesondere im Bereich von 10 bis 40 Gew.-%, bezogen auf die Beschichtungslösung.

Wie bereits erwähnt, werden erfindungsgemäß für die Herstellung der endlosen lichtempfindlichen Aufzeichnungsschichten solche lichtempfindlichen polymeren Aufzeichnungsmassen eingesetzt, die bei Raumtemperatur fest sind, so daß sich hieraus feste, formstabile, bei Raumtemperatur nicht fließende, endlose Aufzeichnungsschichten herstellen lassen, die in ihrer Anwendung einfach und bequem zu handhaben sind. Im übrigen können die erfindungsgemäß hergestellten endlosen, festen, lichtempfindlichen polymeren Aufzeichnungsschichten gleichermaßen positiv oder negativ arbeitend sein und grundsätzlich aus beliebigen, für solche Schichten an sich bekannten, lichtempfindlichen polymeren Aufzeichnungsmassen gebildet werden.

Beispielsweise kommen als lichtempfindliche polymere Aufzeichnungsmassen die bekannten photoabbaubaren Materialien bzw. solche Materialien, die bei Bestrahlung mit aktinischem Licht in Lösungsmitteln löslich werden, in denen sie zuvor unlöslich waren, in Betracht. Hierzu gehören unter anderem die positiv arbeitenden Aufzeichnungsmaterialien auf Basis von ortho-Chinondiazid-Gruppen enthaltenden Verbindungen, wie sie u.a. in der DE-A-20 28 903, der DE-A-22 36 914, der US-A-3 782 939, der US-A-3 837 860 und der US-A-4 193 797 beschrieben sind. Hierzu gehören auch die bekannten lichtempfindlichen polymeren Aufzeichnungsmassen, welche Verbindungen mit einer säurelabilen -C-O-C-Gruppierung und einen photochemischen Säurespender enthalten.

Vorzugsweise werden zur Herstellung der endlosen, festen, lichtempfindlichen polymeren Aufzeichnungsschichten in dem erfindungsgemäßen Verfahren als lichtempfindliche polymere Aufzeichnungsmassen photopolymerisierbare Gemische eingesetzt, welche neben mindestens einem Photopolymerisationsinitiator mindestens eine ethylenisch ungesättigte, photopolymerisierbare Verbindung und mindestens ein Polymeres enthalten. Bei den ethylenisch ungesättigten, photopolymerisierbaren Verbindungen kann es sich sowohl um Monomere, Oligomere und/oder photopolymerisierbare bzw. photovernetzbare Gruppen enthaltende Polymere handeln, wobei in dem photopolymerisierbaren Gemisch vorzugsweise nur ethylenisch ungesättigte, photopolymerisierbare Verbindungen enthalten sind, die zwei oder mehr ethylenische, photopolymerisierbare Doppelbindungen aufweisen, oder Mischungen hiervon mit ethylenisch ungesättigten, photopolymerisierbaren Verbindungen mit nur einer ethylenischen, photopolymerisierbaren Doppelbindung. Wenn es sich bei der ethylenisch ungesättigten, photopolymerisierbaren Verbindung bereits um ein Polymer handelt, ist es möglich, aber nicht zwingend, daß die photopolymerisierbaren Gemische weitere Polymere enthalten. Für den Fall, daß es sich bei den ethylenisch ungesättigten, photopolymerisierbaren Verbindungen um Monomere und/oder Oligomere handelt, enthalten die photopolymerisierbaren Gemische noch ein oder mehrere polymere Bindemittel, die mit den ethylenisch ungesättigten, photopolymerisierbaren Verbindungen verträglich sind. Neben Photoinitiator, ethylenisch ungesättigter, photopolymerisierbarer Verbindung und Polymerem können die als lichtempfindliche polymere Aufzeichnungsmasse für die Herstellung der festen, endlosen Aufzeichnungsschichten dienenden photopolymerisierbaren Gemische in an sich bekannter und üblicher Weise weitere Zusatzstoffe, wie z.B. thermische Polymerisationsinhibitoren, Füllstoffe, Weichmacher, sensitometrische Regler, photochrome Verbindungen bzw. Systeme, Verlaufshilfsmittel und dergl. enthalten. Die für lichtempfindliche polymere Aufzeichnungsmassen in Betracht kommenden photopolymerisierbaren Gemische sind dem Fachmann bekannt und in der einschlägigen Fachliteratur beschrieben.

So sind als Polymere, im allgemeinen das Basismaterial für die photopolymerisierbaren Gemische, die in den Entwicklerlösungsmitteln löslichen oder zumindest dispergierbaren, synthetischen Polymere geeignet, wie beispielsweise Vinylpolymerisate, etwa Polyvinylacetat, teilverseifte Polyvinylacetate, weichgemachte Polyvinylalkohole oder Polyvinylalkohol-Derivate, Styrolpolymerisate und -copolymerisate, wie etwa Styrol-Maleinsäureanhydrid-Copolymerisate, Styrol-Maleinsäurehalbester-Copolymerisate oder Styrol-Butadien- und/oder -Isopren-Copolymerisate, Polymerisate aus überwiegenden Mengen an olefinisch ungesättigten Carbonsäuren mit 3 bis 5 Kohlenstoffatomen und/oder deren Ester und/oder deren Amide, z.B. Polymerisate von (Meth)acrylsäure, (Meth)acrylamid und/oder (Meth)acrylaten von Alkanolen des 1 bis 12 Kohlenstoffatomen oder aliphatischen Diolen und Polyolen, wie Ethylenglykol, 1,4-Butandiol oder Glycerin. Ferner gut geeignet als polymere Bindemittel sind lösliche Polyamide bzw. Copolyamide, Polyimide und Polyamidimide, Polyurethane, z.B. Polyetherurethane oder Polyesterurethane, vorzugsweise mit eingebauten Harnstoffgruppierungen, Melaminformaldehyd- oder Phenolformaldehydharze sowie die üblichen ungesättigten Polyesterharze aus mehrwertigen, insbesondere zweiwertigen, Carbonsäuren und mehrwertigen, insbesondere zweiwertigen, Alkoholen. Insbesondere vorteilhaft für die lichtempfindlichen polymeren Aufzeichnungsmassen sind hierbei solche photopolymerisierbaren Gemische, die mit wäßrigen Entwicklerlösungen entwickelbar, d.h. in wäßrigen Entwicklerlösungen für die Aufzeichnungsschicht löslich oder zumindest dispergierbar, sind.

Für die Herstellung von Flexodruck-Schichten kommen dabei als lichtempfindliche polymere Aufzeichnungsmasse insbesondere solche photopolymerisierbaren Gemische in Betracht, die als polymere Bindemittel Dienpolymerisate, wie z.B. Mehrblock-Copolymerisate aus Styrol, Butadien und/oder Isopren oder Butadien/ Acrylnitril-Copolymerisate, oder auch in wäßrigalkalischen Lösungen lösliche oder dispergierbare elastomere polymere Bindemittel, wie z.B. carboxylierte Butadien/Acrylnitril-Copolymerisate, carboxylierte Styrol-Butadien- und/ oder Isopren-Blockcopolymerisate oder Ethylen-Acrylsäure-Copolymerisate, enthalten. Entsprechende photopolymerisierbare Gemische für lichtempfindliche Aufzeichnungsschichten sind z.B. in der DE-A-22 15 090, der DE-A-29 02 412 und der EP-B-27 612 beschrieben. Für andere Hochdruck- und für Tiefdruckformen haben sich als lichtempfindliche polymere Aufzeichnungsmasse für die Aufzeichnungsschicht insbesondere solche photopolymerisierbaren Gemische bewährt, die als polymeres Bindemittel ein lösliches Polyamid oder Copolyamid oder in Wasser lösliche oder zumindest dispergierbare Polyvinylalkohole bzw. Polyvinylalkohol-Derivate enthalten. Zum einschlägigen Stand der Technik sei diesbezüglich z.B. auf die FR-A-15 20 856, die DE-A-20 61 287, die DE-A-22 02 357, die GB-A-834 337, GB-A-835 849, US-A-3 801 328, US-A-4 272 611, EP-A-70 510, EP-A-70 511, EP-A-129 901 oder DE-A-38 06 270 verwiesen.

Die Auswahl der ethylenisch ungesättigten, photopolymerisierbaren Verbindungen richtet sich in bekannter Weise nach dem in den photopolymerisierbaren Gemischen enthaltenen Polymeren und dem gewünschten Verwendungszweck der nach dem erfindungsgemäßen Verfahren hergestellten Endlos-Druckformen. Als ethylenisch ungesättigte, photopolymerisierbare Verbindungen werden insbesondere die photopolymerisierbaren Monomeren und/oder Oligomeren mit einem Molekulargewicht unter 3000, vorzugsweise mit einem Molekulargewicht bis zu 2000, die mit den mitverwendeten Polymeren verträglich sind, eingesetzt. Zu den bevorzugt verwendeten ethylenisch ungesättigten, photopolymerisierbaren Monomeren und/oder Oligomeren gehören insbesondere die Acryloyl- und/oder Methacryloyl-Gruppen enthaltenden niedermolekularen Verbindungen, wie z.B. Mono-, Di- und Poly-(meth)acrylate, wie sie durch Veresterung von Acrylsäure und/oder Methacrylsäure mit ein- oder mehrwertigen niedermolekularen Alkoholen erhalten werden, wie z.B. die Di- und Tri-(meth)-acrylate von Ethylenglykol, Diethylenglykol, Triethylenglykol, Polyethylenglykolen mit einem Molekulargewicht bis etwa 500, 1,2-Propandiol, 1,3-Propandiol, Polypropylenglykolen mit einem Molekulargewicht bis etwa 500, 2,2-Dimethylpropandiol, 1,4-Butandiol, 1,1,1-Trimethylolpropan, Glycerin oder Pentaerythrit; ferner die Monoacrylate und Monomethacrylate solcher Diole oder Polyole, wie z.B. Ethylenglykol-mono-(meth)acrylat, Propandiol-mono-(meth)acrylat und Di-, Tri- oder Tetraethylenglykol-mono-(meth)acrylat; die (Meth)-acrylate von Monoalkanolen mit 1 bis 8 C-Atomen; Acrylamid, Methacrylamid und die Mono- und Bis-(meth)acrylamide von aliphatischen oder aromatischen Diaminen mit 2 bis 8 C-Atomen, Derivate der (Meth)acrylamide, z.B. N-Hydroxymethyl-(meth)-acrylamid oder insbesondere das Umsetzungsprodukt von 2 Mol N-Hydroxymethyl-(meth)acrylamid mit einem Mol eines aliphatischen Diols, z.B. Ethylenglykol oder Propylenglykol; ferner monomere oder oligomere urethangruppenhaltige Acrylat- oder Methacrylat-Verbindungen sowie insbesondere auch die monomeren oder oligomeren Umsetzungsprodukte von Di- oder Polyepoxyden mit Acrylsäure und/oder Methacrylsäure bzw. die entsprechenden Umsetzungsprodukte von Di- oder Polycarbonsäuren mit Glycidylacrylat und/oder Glycidylmethacrylat, wie z.B. die Umsetzungsprodukte von Bisphenol A-diglycidylether mit (Meth)-acrylsäure, von Butandiol-diglycidylether mit (Meth)acrylsäure oder die Umsetzungsprodukte des 3,4-Epoxycyclohexylmethyl-3',4'-epoxycyclohexancarboxylats mit Acrylsäure und/oder Methacrylsäure.

Die photopolymerisierbaren Gemische enthalten die Polymeren und die ethylenisch ungesättigten, photopolymerisierbaren Monomeren oder Oligomeren im allgemeinen in einer Menge von etwa 50 bis 90 Gew.-% bzw. von 10 bis 50 Gew.-%, jeweils bezogen auf die Summe von Polymer und ethylenisch ungesättigtem, photopolymerisierbarem Monomer oder Oligomer. Der Anteil der ethylenisch ungesättigten, photopolymerisierbaren Monomeren bzw. Oligomeren kann in einzelnen Fällen auch größer oder kleiner sein. So kann der Anteil an den ethylenisch ungesättigten, photopolymerisierbaren Monomeren oder Oligomeren beispielsweise unter 10 Gew.-% abgesenkt werden, wenn in den photopolymerisierbaren Gemischen ungesättigte Polymere mit einem hinreichend hohen Gehalt an photopolymerisierbaren bzw. photovernetzbaren Doppelbindungen enthalten sind; er kann auch über 50 Gew.-% betragen, beispielsweise wenn photopolymerisierbare Oligomere mitverwendet werden, solange die aus den photopolymerisierbaren Gemischen hergestellten lichtempfindlichen Aufzeichnungsschichten bei Raumtemperatur fest sind.

Die Auswahl der geeigneten Polymeren und ethylenisch ungesättigten, photopolymerisierbaren Verbindungen für die photopolymerisierbaren Gemische in Abhängigkeit von der jeweiligen Anwendung der hieraus hergestellten lichtempfindlichen polymeren Aufzeichnungsschichten ist dem Fachmann, z.B. aus den vorstehend zitierten Druckschriften, wohlbekannt. Enthalten die photopolymerisierbaren Gemische, beispielsweise für die Herstellung von Flexodruck-Schichten, elastomere Dienpolymerisate oder Ethylen/Acrylsäure-Copolymerisate, so werden als ethylenisch ungesättigte, photopolymerisierbare Verbindungen vorzugsweise Di- oder Tri-acrylate oder -methacrylate, insbesondere von Di- oder Trialkanolen mit 2 bis 8 C-Atomen, eingesetzt. In photopolymerisierbaren Gemischen mit löslichen Polyamiden, insbesondere in Wasser-Alkohol-Gemischen löslichen Copolyamiden, wählt man als ethylenisch ungesättigte, photopolymerisierbare Verbindungen neben den Di- und Poly-(meth)acrylat-Monomeren besonders solche, die zusätzlich zu den Doppelbindungen noch Hydroxyl- und/oder Amid- und/oder Urethangruppen enthalten, wie (Meth)acrylamide sowie insbesondere die Derivate der (Meth)acrylamide. In den photopolymerisierbaren Gemischen, die als Polymere Polyvinylalkohole, insbesondere teilverseifte Polyvinylacetate oder Polyvinylpropionate mit einem Verseifungsgrad im Bereich von 75 bis 99 mol-%, oder Polyvinylalkohol-Derivate, wie z.B. 1 bis 12 mol-% an Acryloyl- und/oder Methacryloyl-Gruppen enthaltende Polyvinylalkohole, enthalten, werden als ethylenisch ungesättigte, photopolymerisierbare Verbindungen neben Hydroxyalkyl-(meth)acrylaten die Di- und Tri-acrylate bzw. -methacrylate von Di- oder Trialkanolen mit 2 bis 8 C-Atomen, die Di(meth)acrylate von Polyalkylenglykolen sowie insbesondere auch die vorerwähnten Umsetzungsprodukte aus Di- oder Polyepoxiden mit Acrylsäure und/oder Methacrylsäure eingesetzt.

Als Photopolymerisationsinitiatoren, die in den photopolymerisierbaren Gemischen im allgemeinen in einer Menge von 0,05 bis 10 Gew.-%, insbesondere von 0,5 bis 5 Gew.-%, bezogen auf das photopolymerisierbare Gemisch, enthalten sind, kommen die bekannten und üblichen Photopolymerisationsinitiatoren und Systeme für die Auslösung einer Photopolymerisation bei Bestrahlung mit aktinischem Licht in Frage, wie sie hinreichend in der einschlägigen Fachliteratur beschrieben sind. Genannt seien beispielhaft Acyloine und deren Derivate, wie Benzoin, Benzoinalkylether, z.B. Benzoinmonomethylether oder Benzoinisopropylether, α-Methylol-benzoin und dessen Ether oder α-Methylbenzoin und dessen Ether; 1,2-Diketone und deren Derivate, wie Benzil, Benzilketale, insbesondere Benzildimethylketal oder Benzilmethylethylketal;

die als Photoinitiator bekannten und wirksamen Acylphosphinoxid-Verbindungen, insbesondere Acyl-diarylphosphinoxide und speziell Acyl-diphenylphosphinoxide, deren Acylrest sich von einer tertiären aliphatischen oder cycloaliphatischen Carbonsäure oder von einer mindestens in 2,6-Stellung substituierten Benzoesäure ableitet, wie z.B. 2, 4, 6-Trimethylbenzoyl-diphenylphosphinoxid; Benzophenon, Derivate des Benzophenons, Michler's Keton, Derivate von Michler's Keton; Anthrachinon und substituierte Anthrachinone und dgl. Die Photopolymerisationsinitiatoren können allein oder in Mischung miteinander oder auch in Mischung mit den üblichen und bekannten Aktivatoren bzw. Sensibilisatoren, wie z.B. tertiären Aminen, eingesetzt werden.

Darüber hinaus können die photopolymerisierbaren Gemische, die als lichtempfindliche polymere Aufzeichnungsmasse für die Herstellung der erfindungsgemäßen endlosen, festen, lichtempfindlichen polymeren Aufzeichnungsschichten eingesetzt werden, die an sich üblichen und bekannten Zusatz- und/oder Hilfsstoffe zur Verbesserung oder Modifizierung ihrer Handhabbarkeit bzw. ihrer anwendungstechnischen Eigenschaften in den hierfür üblichen und bekannten wirksamen Mengen enthalten. Zu diesen Zusatz- und/oder Hilfsstoffen gehören die thermischen Polymerisationsinhibitoren, wie z.B. Hydrochinon, p-Methoxyphenol, m-Dinitrobenzol, p-Chinon, Methylenblau, 2,6-Di-tert.-butyl-p-kresol und Nitrosamine, wie N-Nitrosodiphenylamin oder die Salze, insbesondere die Alkali- oder Aluminiumsalze, des N-Nitrosocyclohexyl-hydroxylamins. Die thermischen Polymerisationsinhibitoren werden im allgemeinen in einer Menge von 0,01 bis 2 Gew.-%, bezogen auf das photopolymerisierbare Gemisch, verwendet.

Weiterhin können die photopolymerisierbaren Gemische Füllstoffe, wie z.B. Glas, Glimmer, andere Polymere und dgl., enthalten. Im Fall von endlosen, lichtempfindlichen polymeren Aufzeichnungsschichten für die Herstellung von Tiefdruckformen enthalten die photopolymerisierbaren Gemische in vorteilhafter Weise als Füllstoffe feinteilige, harte, abrasive Partikel mit einer Härte größer 4,0, insbesondere von 6 oder mehr, auf der Mohs'schen Härteskala. Die mittlere Teilchengröße dieser abrasiven Partikel soll dabei im Bereich von 0,1 bis 6 $\mu$m liegen, wobei höchstens 5 %, vorzugsweise weniger als 1 %, der abrasiven Partikel Längsausdehnungen größer als 10 $\mu$m haben sollen. Für solche abrasiven Partikel kommen insbesondere mineralische Füllstoffe und Pigmente, wie z.B. Siliciumdioxid, insbesondere Quarzmehl und Cristobalit; Silikate, insbesondere Aluminiumsilikate oder Silikatgläser; Aluminiumoxide, insbesondere Korund; Titandioxid, Siliciumcarbid, Wolframcarbid und andere, in Betracht. Die feinteiligen abrasiven Partikel können dabei in an sich bekannter Weise auch oberflächlich behandelt oder beschichtet sein, um beispielsweise die Dispergierbarkeit und/oder die Haftung in den photopolymerisierbaren Gemischen zu verbessern. Vorteilhafterweise werden solche abrasiven Partikel verwendet, die für das für den Photopolymerisationsinitiator aktinische Licht weitgehend durchlässig sind, wobei es des weiteren von Vorteil ist, wenn die Brechungsindices der abrasiven Partikel und des photopolymerisierbaren Gemisches aneinander angeglichen sind. Die abrasiven Partikel sind in den photopolymerisierbaren Gemischen, die für lichtempfindliche polymere Aufzeichnungsschichten für Tiefdruckformen Verwendung finden, im allgemeinen in einer Menge von 2 bis 50 Gew.-%, vorzugsweise von 5 bis 30 Gew.-%, bezogen auf das die abrasiven Partikel enthaltende photopolymerisierbare Gemisch, enthalten. Im übrigen sei in diesem Zusammenhang auf die in der EP-A-70 511 beschriebenen diesbezüglichen speziellen Ausführungs- und Ausgestaltungsformen verwiesen.

Auch ist es vorteilhaft, wenn die erfindungsgemäß eingesetzten photopolymerisierbaren Gemische sensitometrische Regler enthalten. Besonders günstige Reglersysteme sind beispielsweise in der EP-A-114 341 beschrieben und werden aus einer Mischung bestimmter Farbstoffe mit milden Reduktionsmitteln gebildet. Als Farbstoffe kommen dabei solche aus der Reihe der Acridiniumfarbstoffe, Phenoxaziniumfarbstoffe, Phenaziniumfarbstoffe und Phenothiaziniumfarbstoffe in Betracht. Beispiele für geeignete Reduktionsmittel in diesen Reglersystemen sind u.a. Ascorbinsäure, Anethol, Thioharnstoff, Diethylallylthioharnstoff und Hydroxylamin-Derivate, insbesondere N-Allylthioharnstoff und die Salze des N-Nitrosocyclohexylhydroxylamins. Die sensitometrischen Regler sind üblicherweise in Mengen von etwa 0,005 bis 5 Gew.-%, insbesondere von 0,01 bis 1 Gew.-%, bezogen auf das photopolymerisierbare Gemisch, in dem photopolymerisierbaren Gemisch enthalten.

Als weitere Zusatz- und/oder Hilfsstoffe für die photopolymerisierbaren Gemische sind beispielsweise Weichmacher, Farbstoffe, Pigmente, Verlaufshilfsmittel oder Thixotropierungsmittel und dgl. zu nennen.

Zur Herstellung der erfindungsgemäßen endlosen, lichtempfindlichen polymeren Aufzeichnungsschichten werden zunächst die Bestandteile der diese Aufzeichnungsschichten bildenden, lichtempfindlichen polymeren Aufzeichnungsmassen homogen miteinander vermischt. Dieses Vermischen der Komponenten der lichtempfindlichen polymeren Aufzeichnungsmassen kann nach den hierfür bekannten Mischverfahren z.B. in einem Mischer, Kneter oder Extruder erfolgen und wird vorzugsweise in Lösung in einem geeigneten Lösungsmittel oder Lösungsmittelgemisch durchgeführt. Wird die Mischung der Komponenten für die lichtempfindliche polymere Aufzeichnungsmasse in Lösung vorgenommen, so wird diese Lösung praktischerweise so hergestellt, daß sie anschließend gleich zum Beschichten der zylinderförmigen Oberfläche verwendet werden kann. Das homogene Mischen der Komponenten der lichtempfindlichen polymeren Aufzeichnungsmasse in einem Kneter oder Extruder erfolgt insbesondere dann, wenn die Beschichtung der zylinderförmigen Oberfläche mit der lichtempfindlichen polymeren Aufzeichnungsmasse in schmelzflüssiger Form erfolgen soll.

Die mit der lichtempfindlichen polymeren Aufzeichnungsschicht endlos zu beschichtende zylinderförmige Oberfläche des Trägers kann - wie bereits erwähnt - vor dem Aufbringen der lichtempfindlichen polymeren Aufzeichnungsschicht mit einer oder mehreren Hilfs- und/oder Zwischenschichten, wie Haftschichten, Lichthofschutzschichten, elastischen Unterschichten und dgl., versehen oder einer mechanischen, chemischen oder elektrochemischen Vorbehandlung unterworfen worden sein. Diese Vorbehandlung der zylinderförmigen Oberfläche des Trägers kann nach den hierfür üblichen und bekannten Verfahrenweisen erfolgen. Gegebenenfalls mitverwendete Hilfs- und/oder Zwischenschichten werden auf die zylinderförmige Trägeroberfläche nach den zum Aufbringen solcher Schichten an sich bekannten Verfahren, z.B. durch Sprühen, Gießen, Tauchen, Kleben oder durch Extrusionsbeschichtung, aufgebracht.

Auf die gegebenenfalls so vorbehandelte oder vorbeschichtete zylinderförmige Oberfläche des Trägers wird dann erfindungsgemäß die lichtempfindliche polymere Aufzeichnungsmasse in fließfähiger Form, insbesondere als Lösung in einem leicht verdampfbaren Lösungsmittel, so aufgebracht, daß auf der zylinderförmigen Trägeroberfläche eine gleichmäßige, endlose Schicht aus der Beschichtungsmasse gebildet wird. Der Auftrag der fließfähigen, lichtempfindlichen polymeren Aufzeichnungsmasse auf die zylinderförmige Oberfläche kann nach an sich beliebigen Methoden mittels der hierfür bekannten Verfahrenstechniken erfolgen, wie sie beispielsweise in der DE-A-26 40 105 erwähnt und beschrieben sind. Besonders geeignet für die Beschichtung der zylinderförmigen Trägeroberfläche mit der fließfähigen, lichtempfindlichen polymeren Aufzeichnungsmasse sind das Tauch-, Gieß- oder Spritzverfahren.

Bei der Tauchbeschichtung wird der zu beschichtende Formzylinder bzw. die zu beschichtende Formzylinder-Hülse in ein Bad mit der Beschichtungslösung aus der lichtempfindlichen polymeren Aufzeichnungsmasse eingetaucht, wonach entweder das Bad mit der Beschichtungslösung mit einer definierten Geschwindigkeit abgesenkt oder der Formzylinder bzw. die Formzylinder-Hülse mit einer definierten Geschwindigkeit aus dem Bad mit der Beschichtungslösung herausgezogen wird, bei gleichzeitiger Fixierung der an der zylinderförmigen Oberfläche haftenden, lichtempfindlichen polymeren Aufzeichnungsmasse durch Verfestigung. Der Formzylinder bzw. die Formzylinder-Hülse kann bei der Tauchbeschichtung auch um seine bzw. ihre Achse gedreht werden. Der Formzylinder bzw. die Formzylinder-Hülse kann längs oder quer zur axialen Richtung in das Bad mit der Beschichtungslösung aus der lichtempfindlichen polymeren Aufzeichnungsmasse ein- bzw. ausgetaucht werden. Der Vorgang der Tauchbeschichtung kann dabei einmal oder auch mehrere Male hintereinander wiederholt ausgeführt werden. In einer Ausführungsform des Tauchverfahrens wird der Formzylinder bzw. die Formzylinder-Hülse achsparallel derart in das Beschichtungsbad eingetaucht, daß der Formzylinder bzw. die Formzylinder-Hülse nur teilweise, d.h. nur mit seinem bzw. ihrem unteren Teil, in das Beschichtungsbad eintaucht, und dann so gedreht, daß die zu beschichtende Oberfläche ständig wechselweise in das Beschichtungsbad ein- bzw. austaucht. Bei Beendigung des Beschichtungsvorganges kann dann das Beschichtungsbad abgesenkt oder der beschichtete Formzylinder bzw. die beschichtete Formzylinder-Hülse aus dem Beschichtungsbad, vorzugsweise unter weiterem Drehen, herausgezogen werden. Bei mehrfacher Wiederholung des Tauchvorgangs wird die an der zylinderförmigen Oberfläche haftende lichtempfindliche polymere Aufzeichnungsmasse vor jedem erneuten Tauchvorgang ganz oder teilweise verfestigt.

Bei den Gieß-Verfahren zur Beschichtung der zylinderförmigen Oberflächen mit der fließfähigen, lichtempfindlichen polymeren Aufzeichnungsmasse wird in aller Regel ebenfalls so gearbeitet, daß die zylinderförmige Oberfläche während des Beschichtungsvorganges ständig um ihre Achse gedreht wird. Das Aufgießen der fließfähigen lichtempfindlichen polymeren Aufzeichnungsmassen, in aller Regel in Form einer Beschichtungslösung, auf die sich drehende zylinderförmige Oberfläche kann durch einen über der zylinderförmigen Oberfläche angeordneten und sich über die gesamte axiale Länge der zylinderförmigen Oberfläche erstreckenden Schlitz oder Spalt in Form eines Vorhangs erfolgen. Die Beschichtungslösung kann aber auch mittels eines üblichen und bekannten Rakelgießers auf die zylinderförmige Oberfläche aufgebracht oder mittels einer Düse spiralförmig auf die zylinderförmige Oberfläche aufgegossen werden. Im letztgenannten Fall werden die Form der Düse, ihr Abstand von der zylinderförmigen Oberfläche, die Bewegung der Düse relativ zur zylinderförmigen Oberfläche während der Beschichtung sowie die Drehzahl des zu beschichtenden Formzylinders bzw. der zu beschichtenden Formzylinder-Hülse so aufeinander abgestimmt, daß sich auf der zylinderförmigen Oberfläche ein gleichmäßiger, geschlossener Film aus der fließfähigen, lichtempfindlichen polymeren Aufzeichnungsmasse bildet. Die auf die zylinderförmige Oberfläche aufgegossene endlose Schicht aus der lichtempfindlichen polymeren Aufzeichnungsmasse wird dann unter ständigem Drehen des Formzylinders bzw. der Formzylinder-Hülse verfestigt. Auch die Gieß-Beschichtung kann in einem oder in mehreren aufeinanderfolgenden Schritten durchgeführt werden, wobei im letzten Fall die bereits auf die zylinderförmige Oberfläche aufgegossene Schicht vor dem Aufgießen einer weiteren Schichtlage ganz oder teilweise verfestigt wird.

In vorteilhafter Weise wird die Beschichtungslösung aus der lichtempfindlichen polymeren Aufzeichnungsmasse durch Spritzen mittels einer geeigneten Spritzeinrichtung auf die zu beschichtende zylinderförmige Oberfläche aufgebracht. Dabei kann entweder die Spritzeinrichtung an der zu beschichtenden Oberfläche des Formzylinders bzw. der Formzylinder-Hülse entlang geführt werden, man kann aber auch den Formzylinder bzw. die Formzylinder-Hülse mit der zu beschichtenden Oberfläche an der Spritzeinrichtung entlang führen. Auch bei dieser Methode der Beschichtung wird der Formzylinder bzw. die Formzylinder-Hülse während des Beschichtungsvorganges ständig um seine bzw. ihre Achse gedreht. Die Spritzeinrichtung kann dabei sowohl mit einem inerten Trägergas, wie beispielsweise Luft, vorzugsweise aber einem sauerstofffreien Gas, wie z.B. Stickstoff, betrieben werden oder aber auch einfach nur mit Flüssigkeitsdruck. Nach dem Aufspritzen auf die zylinderförmige Oberfläche wird die lichtempfindliche polymere Aufzeichnungsmasse verfestigt. Das Aufbringen der endlosen, lichtempfindlichen polymeren Aufzeichnungsschicht auf die zylinderförmige Oberfläche durch Aufspritzen kann dabei in einem oder auch in mehreren, aufeinanderfolgenden Schritten erfolgen, wobei im letztgenannten Fall vor dem Aufspritzen einer neuen Schichtlage die zuvor aufgebrachte Schichtlage ganz oder teilweise verfestigt werden kann.

Die fließfähige, lichtempfindliche polymere Aufzeichnungsmasse wird in einer solchen Dicke endlos auf die zylinderförmige Oberfläche aufgebracht, daß die erzeugte endlose, lichtempfindliche polymere Aufzeichnungsschicht nach dem Verfestigen die für den jeweiligen Anwendungszweck gewünschte Dicke aufweist. Die Schichtdicke der festen, endlosen, lichtempfindlichen polymeren Aufzeichnungsschicht kann dabei, je nach Anwendungszweck, in weiten Grenzen variieren und liegt in aller Regel im Bereich von etwa 50 bis 6000 $\mu$m.

Für die Herstellung von Flexodruckformen hat die endlose, feste, lichtempfindliche polymere Aufzeichnungsschicht im allgemeinen eine Schichtdicke von etwa 1000 bis 6000 $\mu$m. Für die Herstellung von Tiefdruckformen liegt die Schichtdicke der festen, endlosen, lichtempfindlichen polymeren Aufzeichnungsschicht vorzugsweise im Bereich von 50 bis 500 $\mu$m, insbesondere im Bereich von etwa 100 bis 300 $\mu$m, bei sonstigen Hochdruckformen üblicherweise im Bereich von etwa 200 bis 800 $\mu$m.

Je nach dem, ob die lichtempfindliche polymere Aufzeichnungsmasse auf die zylinderförmige Oberfläche in schmelzflüssiger Form oder in Form einer Lösung aufgebracht wird, erfolgt das Verfestigen der endlosen, lichtempfindlichen polymeren Aufzeichnungsschicht nach dem Beschichtungsvorgang entweder durch bloßes Abkühlen auf Raumtemperatur oder durch Verdampfen des Lösungsmittels, gegebenenfalls unter direkter oder indirekter Wärmezufuhr. Während der Verfestigung der endlosen, lichtempfindlichen polymeren Aufzeichnungsschicht wird der beschichtete Formzylinder bzw. die beschichtete Formzylinder-Hülse in aller Regel ständig, vorzugsweise mit konstanter Geschwindigkeit, gedreht. Die Geschwindigkeit, mit der die Verfestigung der auf die zylinderförmige Oberfläche aufgebrachten, endlosen, lichtempfindlichen polymeren Aufzeichnungsschicht erfolgt, ist nicht besonders kritisch und kann in weiten Grenzen variieren. Aus ökonomischen Gründen wird man die Verfestigungs-Geschwindigkeit nicht unnötig langsam wählen; andererseits darf die Verfestigung nicht so schnell erfolgen, daß hierdurch die Ausbildung einer homogenen, gleichmäßigen Aufzeichnungsschicht und die Ausbildung einer definierten Oberflächenstruktur durch die erfindungsgemäße Walzenbehandlung gestört würde. Überlicherweise beträgt die Dauer für die Verfestigung der auf die zylinderförmige Oberfläche aufgebrachten, endlosen, lichtempfindlichen polymeren Aufzeichnungsschicht etwa 2 bis 30 Minuten.

Während der Verfestigung wird die endlose, lichtempfindliche polymere Aufzeichnungsschicht erfindungsgemäß einer Walzenbehandlung unterworfen. Dieses geschieht am einfachsten und besten derart, daß der mit der endlosen, lichtempfindlichen polymeren Aufzeichnungsschicht beschichtete Formzylinder oder die beschichtete Formzylinder-Hülse kontinuierlich, vorzugsweise mit konstanter Geschwindigkeit, um seine bzw. ihre Achse gedreht wird, während gleichzeitig die achsparallel laufende Walze zur Einstellung der definierten Oberflächenstruktur an die Oberfläche der sich verfestigenden, endlosen, lichtempfindlichen polymeren Aufzeichnungsschicht angestellt wird. Wenn auch nicht zwingendermaßen erforderlich, so wird doch vorzugsweise die Walze zur Oberflächenbehandlung unabhängig angetrieben, und zwar insbesondere mit einer solchen Umdrehungsgeschwindigkeit, die der Umdrehungsgeschwindigkeit des rotierenden Formzylinders bzw. der rotierenden Formzylinder-Hülse angepaßt ist. Für die erfindungsgemäße Oberflächenbehandlung wird die Walze derart an die Oberfläche der endlosen, lichtempfindlichen polymeren Aufzeichnungsschicht angestellt, daß die Oberflächen gerade in Berührung sind, d.h. daß die gewünschte Oberflächenstruktur von der Walze zur Oberflächenbehandlung auf die sich verfestigende, endlose, lichtempfindliche polymere Aufzeichnungsschicht übertragen wird. Da die endlose, lichtempfindliche polymere Aufzeichnungsschicht während der erfindungsgemäßen Oberflächenbehandlung noch im Stadium der Verfestigung ist, kann der Anstelldruck der Walze zur Oberflächenbehandlung an die Oberfläche der endlosen, lichtempfindlichen polymeren Aufzeichnungsschicht relativ gering sein. Für den Fall, daß die endlose, lichtempfindliche polymere Aufzeichnungsschicht in mehreren, aufeinanderfolgenden Beschichtungsschritten auf die zylinderförmige Oberfläche des Formzylinders bzw. der Formzylinder-Hülse aufgebracht worden ist, findet die erfindungsgemäße Walzenbehandlung selbstverständlich erst nach dem letzten Beschichtungsschritt während der Verfestigung der letzten Lage der endlosen, lichtempfindlichen polymeren Aufzeichnungsschicht statt.

Die Walze für die erfindungsgemäße Oberflächenbehandlung der endlosen, lichtempfindlichen polymeren Aufzeichnungsschicht kann im Prinzip aus beliebigem Material sein, besteht aber vorzugsweise aus Metall, wie z.B. Stahl, Aluminium, Kupfer, Chrom oder dergleichen; sie kann aber auch z.B. aus Kunststoff gebildet werden. Wesentlich ist, daß die Oberfläche der Walze für die erfindungsgemäße Oberflächenbehandlung aus einem solchen Material gebildet wird, an welchem die sich verfestigende, endlose, lichtempfindliche polymere Aufzeichnungsschicht unter den Bedingungen der erfindungsgemäßen Walzenbehandlung nicht haftet. Gegebenenfalls kann die Oberfläche der Walze für die erfindungsgemäße Oberflächenbehandlung mit einer Anti-Haftschicht, beispielsweise aus Polytetrafluorethylen oder dergleichen, beschichtet oder mit einer Antihaft-Folie, z.B. aus Kunststoff, umwickelt sein.

Durch die erfindungsgemäße Walzenbehandlung der endlosen, lichtempfindlichen polymeren Aufzeichnungsschicht während ihrer Verfestigung werden zum einen eventuelle Dickenschwankungen der auf die zylinderförmige Oberfläche aufgebrachten, endlosen, lichtempfindlichen polymeren Aufzeichnungsschicht ausgeglichen und wird eine Aufzeichnungsschicht mit exakt zylindrischer Oberfläche hoher Präzision erhalten, ohne daß hierzu ein besonderer Verfahrensschritt oder eine Nachbehandlung notwendig wären. Daher können auch konische Formzylinder-Hülsen ohne Probleme als Träger in dem erfindungsgemäßen Verfahren eingesetzt werden. Zum anderen wird der endlosen, lichtempfindlichen polymeren Aufzeichnungsschicht durch die erfindungsgemäße Walzenbehandlung während der Schichtverfestigung die gewünschte, definierte Oberflächenstruktur gegeben. Dies kann dadurch geschehen, daß man für die erfindungsgemäße Walzenbehandlung eine Walze einsetzt, deren Oberfläche ein Spiegelbild der für die endlose, lichtempfindliche polymere Aufzeichnungsschicht gewünschten Oberflächenstruktur darstellt, oder daß man diese Walze mit einer Folie oder dergleichen mit entsprechender Oberflächenstruktur, die dann auf die Oberfläche der endlosen, lichtempfindlichen polymeren Aufzeichnungsschicht übertragen wird, umwickelt bzw. umhüllt. Die Oberflächenstruktur wird dabei so gewählt, daß sie nach Übertragung auf die endlose, lichtempfindliche polymere Aufzeichnungsschicht dieser bzw. der hieraus hergestellten Druckform die gewünschten Einfärb- und Farbübertragungseigenschaften und auch sonstigen reproduktionstechnischen Eigenschaften verleiht. Als Strukturen kommen dabei erfindungsgemäß einerseits ganz glatte Oberflächen, rauhe Oberflächen oder Oberflächen mit einem bestimmten Muster, beispielsweise einer Linien-, Gitter- oder Rasterstruktur, in Betracht. Hinsichtlich des Rauhigkeitsprofils werden Strukturen bevorzugt, deren Rauhtiefe $R_A$, je nach Anwendungsgebiet, im Bereich von 0,01 bis 10 $\mu$m, insbesondere 0,05 bis 5 $\mu$m, liegt. Die Rauhtiefe $R_A$ wird nach den üblichen Bestimmungsmethoden, beispielsweise mittels Perthometer oder Rasterelektronenmikroskopie, gemessen.

Für die Herstellung von Tiefdruckformen werden im allgemeinen glatte Oberflächen der Druckschichten gewünscht, von denen die Oberflächenfarbe nach dem Einfärben der farbführenden Vertiefungen (Näpfchen) gut und problemlos abgerakelt werden kann, so daß es beim Drucken nicht zum Tonen der nicht farbführenden Bereiche kommt. In diesem Fall wird die erfindungsgemäße Oberflächenbehandlung mit einer glatten, unstrukturierten, vorzugsweise polierten, Walze durchgeführt. Für verschiedene Anwendungszwecke kann es jedoch auch beim Tiefdruck wünschenswert sein, daß die Oberfläche der Tiefdruckform beim Drucken in definierter und reproduzierbarer Weise tont, d.h., daß beim Drucken nicht nur Farbe aus den Näpfchen heraus, sondern auch von der Oberfläche der Tiefdruckform her auf den Bedruckstoff übertragen wird. Dies kann beispielsweise gefordert sein, wenn man Druckerzeugnisse mit verschiedenen Hintergrundfarben oder Hintergrundmustern zur Erzielung besonderer reproduktionstechnischer Effekte herstellen will. Das Erzeugen einer bestimmten Hintergrundfarbe bzw. eines bestimmten Hintergrundmusters ist besonders kritisch und bedarf einer sehr genau und definiert geführten und gesteuerten Farbübertragung. Mit dem erfindungsgemäßen Verfahren ist es möglich, Tiefdruckformen mit hierfür geeigneten Oberflächen in einfacher, gezielter und reproduzierbarer Weise herzustellen. Zu diesem Zweck wird durch die erfindungsgemäße Walzenbehandlung der endlosen, lichtempfindlichen polymeren Aufzeichnungsschicht beispielsweise ein Linien-, Gitter- oder Rastermuster aufgeprägt, wobei sich die Form des Linien-, Gitter- bzw. Rastermusters, Linienbreite und -abstände sowie die genaue Gitter- bzw. Rasterstruktur nach dem zu erzielenden Effekt, d.h. dem gewünschten Hintergrundfarbton bzw. Hintergrundmuster, richten. Für den Flexodruck werden im allgemeinen Druckformen mit einer rauhen, gut farbannehmenden Oberfläche bevorzugt. Das Rauhigkeitsprofil kann dabei beliebig sein; die Rauhtiefen liegen in dem oben angegebenen Bereich.

Die erfindungsgemäße Walzenbehandlung der Oberfläche der endlosen, lichtempfindlichen polymeren Aufzeichnungsschicht während der Schichtverfestigung erfordert ansonsten keine speziellen Verfahrensmaßnahmen oder -bedingungen. Die erfindungsgemäße Walzenbehandlung wird bei den Temperaturen durchgeführt, die für die Schichtverfestigung, beispielsweise das Verdampfen des Lösungsmittels aus der aufgetragenen Schicht, angewandt werden. Diese Temperaturen liegen üblicherweise im Bereich von etwa 20 °C bis 60 °C (hierbei handelt es sich um die Umgebungstemperatur der endlosen, lichtempfindlichen polymeren Aufzeichnungsschicht während der Schichtverfestigung). Eine weitere, besondere Nachbehandlung der nach dem erfindungsgemäßen Verfahren hergestellten, verfestigten, endlosen, lichtempfindlichen polymeren Aufzeichnungsschicht ist nicht erforderlich. Ein besonderer Vorteil des erfindungsgemäßen Verfahrens ist neben seiner Einfachheit die hohe Variabilität und leichte Anpaßbarkeit an die jeweils von der anwendungstechnischen Seite her geforderten Bedingungen.

Die erfindungsgemäß auf der zylinderförmigen Oberfläche, z.B. eines Formzylinder oder einer Formzylinder-Hülse, hergestellten, endlosen, lichtempfindlichen polymeren Aufzeichnungsschichten können anschließend in an sich bekannter Weise durch bildmäßiges Belichten mit aktinischem Licht und Entwickeln, z.B. mit einem geeigneten Entwicklerlösungsmittel, zu Endlos-Druckformen sowohl für den konventionellen Hochdruck, den Flexodruck oder auch den Tiefdruck verarbeitet werden. Der bildmäßigen Belichtung kann dabei eventuell eine kurze, vollflächige Vorbelichtung vorangestellt sein; an die Entwicklung können sich weitere Nachbehandlungsschritte anschließen, wozu insbesondere die Trocknung und/oder eine nicht-bildmäßige Nachbelichtung gehören. Zur Vorbelichtung, bildmäßigen Belichtung und Nachbelichtung eignen sich die üblichen, aktinische Strahlung, insbesondere in Wellenlängenbereich von etwa 300 bis 420 nm, emittierenden Lichtquellen, wie UV-Fluoreszenzröhren, Quecksilberhoch-, -mittel- oder -niederdruckstrahler, superaktinische Leuchtstoffröhren, Xenon-Impulslampen, metalljodiddotierte Lampen, UV-Laser und ähnliche. Der Belichtungsvorgang kann dabei in handelsüblichen Rundbelichtern durchgeführt werden. Die genaue Belichtungszeit hängt von der Art der für die Herstellung der endlosen, lichtempfindlichen polymeren Aufzeichnungsschicht verwendeten lichtempfindlichen polymeren Aufzeichnungsmasse ab und kann in üblicher Weise durch wenige Vorversuche leicht ermittelt werden. Das Auswaschen bzw. Entwickeln der bildmäßig belichteten Schicht kann in den handelsüblichen Geräten, z.B. Sprühwaschern oder Bürstenwaschern, oder auf sonst geeignete andere Weise mittels der für die jeweils verwendeten lichtempfindlichen polymeren Aufzeichnungsmassen üblichen und bekannten Entwicklerflüssigkeiten bzw. Auswaschlösungsmittel durchgeführt werden.

Die nach dem erfindungsgemäßen Verfahren hergestellten Endlos-Druckformen zeichnen sich durch ihre sehr guten reproduktionstechnischen Eigenschaften, insbesondere ihr gutes Druckverhalten und ihre hohe Druckqualität, aus und liefern daher ausgezeichnete Druckergebnisse im Rollenrotationsdruck.

Die Erfindung wird durch die nachfolgenden Beispiele näher erläutert. Die in den Beispielen angegebenen Teile und Prozente beziehen sich, sofern nicht anders vermerkt, auf das Gewicht.

Beispiel 1

Zunächst wurde eine Beschichtungslösung einer photopolymerisierbaren Aufzeichnungsmasse aus folgenden Komponenten hergestellt:

| | |
|---|---|
| 57,0 % | eines teilverseiften Polyvinylacetats (Verseifungsgrad 88 mol.%, mittlerer Polymerisationsgrad: 500) |
| 40,4 % | des Umsetzungsproduktes von 1 Mol Butan-1,4-diol-di-glycidylether mit 2 Mol Acrylsäure, |
| 2,0 % | Benzildimethylketal, |
| 0,55 % | des Kaliumsalzes von N-Nitrosocyclohexylhydroxylamin und |
| 0,05 % | Safranin T (C. I. 50240) |

Die Beschichtungslösung wurde 30 %ig in Wasser angesetzt. Zur Herstellung einer festen, endlosen, lichtempfindlichen polymeren Aufzeichnungsschicht wurde der zu beschichtende Formzylinder in die Lösung ein- und ausgetaucht und die auf der Formzylinder-Oberfläche verbliebene Schicht der Beschichtungslösung unter Verdampfen des Wasser verfestigt. Der Beschichtungsvorgang wurde solange wiederholt, bis eine 500 $\mu$m dicke lichtempfindliche polymere Aufzeichnungsschicht aus der photopolymerisierbaren Aufzeichnungsmasse auf der Oberfläche des Formzylinders ausgebildet war. Nach dem letzten Tauchvorgang wurde der so beschichtete Formzylinder unter ständigem Drehen mit 60°C heißer Luft getrocknet, wobei die Oberfläche der Schicht gleichzeitig mit einer Strukturwalze in Kontakt gebracht wurde, deren Oberflächenrauhigkeit 2 $\mu$m betrug. Die feste, endlose, lichtempfindliche Aufzeichnungsschicht wies nach der Schichtverfestigung eine der Oberfläche der Strukturwalze entsprechende Oberflächenrauhigkeit auf. Nach bildmäßiger Belichtung in einem Rundbelichter, Auswaschen der nichtbelichteten Schichtbereiche mit Wasser, Trocknen und vollflächiger Nachbelichtung wurde eine Endlos-Druckform für den Hochdruck erhalten, die gute reproduktionstechnische Eigenschaften aufwies.

Vergleichsbeispiel 1

Es wurde wie in Beispiel I verfahren, jedoch mit dem Unterschied, daß während der Schichtverfestigung ohne Einsatz der Strukturwalze getrocknet wurde. Die Oberflächenrauhigkeit der Endlos-Schicht betrug diesmal nur 0,5 $\mu$m. Das Farbübertragungsverhalten und die drucktechnischen Eigenschaften der so hergestellten Endlos-Druckform waren deutlich schlechter als die der gemäß Beispiel 1 hergestellten erfindungsgemäßen Druckform.

Beispiel 2

Zunächst wurde eine Beschichtungslösung einer photopolymerisierbaren Aufzeichnungsmasse aus folgenden Komponenten hergestellt:

| | |
|---|---|
| 54,0 % | eines in wäßrigem Alkohol löslichen Mischpolyamids (Ultramid® U1C), |
| 18,4 % | des Umsetzungsproduktes aus einem Mol Ethylenglykol mit zwei Molen N-Methylolacrylamid, |
| 15,0 % | Quarzmehl mit einer mittleren Teilchengröße von 2 $\mu$m, |
| 2,0 % | Benzildimethylketal, |
| 0,55 % | des Kaliumsalzes von N-Nitrosocyclohexylhydroxylamin und |
| 0,05 % | Safranin T (C.I. 50240) |

Als Lösungsmittel für die Beschichtungslösung diente Methanol. Der Feststoffgehalt der Beschichtungslösung betrug 15 %. Mit dieser Beschichtungslösung wurde ein Formzylinder nach dem Spritzverfahren so beschichtet, daß eine Trockenschichtdicke von 100 $\mu$m erreicht wurde. Während der Trocknung wurde die aufgespritzte endlose, lichtempfindliche polymere Aufzeichnungsschicht aus der Beschichtungslösung in Kontakt mit einer Strukturwalze gebracht, deren Oberflächenrauhigkeit auf 0,1 $\mu$m eingestellt war. Die aufgespritzte, endlose, lichtempfindliche polymere Aufzeichnungsschicht wurde unter ständigem Drehen des Formzylinders mit 40°C warmer Luft getrocknet, wobei sie in ständigem Kontakt mit der Strukturwalze war. Die erhaltene feste, endlose, lichtempfindliche polymere Aufzeichnungsschicht zeigte nach der Trocknung eine der Oberfläche der Strukturwalze entsprechende Oberflächenrauhigkeit. Nach der bildmäßigen Belichtung in einem Rundbelichter, dem Auswaschen der nicht belichteten Schichtbereiche mit einem Isopropanol/Wasser-Gemisch, Trocknen, Nachbelichten und Nacherhitzen wurde eine Endlos-Druckform für den Tiefdruck erhalten, die exzellente Druckmuster lieferte.

Vergleichsbeispiel 2

Es wurde wie in Beispiel 2 beschrieben verfahren, nur daß diesmal bei der Trocknung der aufgespritzten, endlosen, lichtempfindlichen polymeren Aufzeichnungsschicht ohne Verwendung einer Strukturwalze getrockent wurde. Die erhaltene Schichtoberfläche war ungleichmäßig und zeigte schwankende Rauhigkeitswerte $\geq$ 0,5 $\mu$m; die hieraus hergestellte Druckform konnte wegen unerwünschten Tonens der Oberfläche nicht für Qualitätsdruckerzeugnisse verwendet werden.

**Patentansprüche**

1. Verfahren zur Herstellung einer endlosen, festen, lichtempfindlichen polymeren Aufzeichnungsschicht auf einer zylinderförmigen Oberfläche für die Herstellung von Endlos-Druckformen, bei dem die die Aufzeichnungsschicht bildende lichtempfindliche polymere Aufzeichnungsmasse in fließfähiger Form unter Ausbildung einer endlosen Schicht auf die zylinderförmige Oberfläche aufgebracht und darauf verfestigt wird, dadurch gekennzeichnet, daß man der Oberfläche der endlosen, lichtempfindlichen polymeren Aufzeichnungsschicht während der Schichtverfestigung durch Walzenbehandlung eine definierte Oberflächenstruktur gibt.

2. Verfahren gemäß Anspruch 1, dadurch gekennzeichnet, daß die zu beschichtende zylinderförmige Oberfläche vor dem Aufbringen der lichtempfindlichen polymeren Aufzeichnungsmasse mit einer Haftschicht versehen worden ist.

3. Verfahren nach einem der Ansprüche 1 oder 2, dadurch gekennzeichnet, daß die lichtempfindliche polymere Aufzeichnungsmasse aus einem ein polymeres Bindemittel enthaltenden photopolymerisierbaren Gemisch gebildet wird.

4. Verfahren nach einem der Ansprüche 1 bis 3, dadurch gekennzeichnet, daß die lichtempfindliche polymere Aufzeichnungsmasse abrasive Füllstoffe enthält.

5. Verfahren nach einem der Ansprüche 1 bis 4, dadurch gekennzeichnet, daß die lichtempfindliche polymere Aufzeichnungsmasse in Form einer Beschichtungslösung auf die zylinderförmige Oberfläche aufgebracht wird.

6. Verfahren nach einem der Ansprüche 1 bis 5, dadurch gekennzeichnet, daß die lichtempfindliche polymere Aufzeichnungsmasse durch Tauchen, Spritzen oder Gießen auf die zylinderförmige Oberfläche aufgebracht wird.

7. Verfahren zur Herstellung von Endlos-Druckformen, bei dem man eine zylinderförmige Oberfläche mit einer fließfähigen lichtempfindlichen polymeren Aufzeichnungsmasse endlos beschichtet, die so erzeugte endlose, lichtempfindliche polymere Aufzeichnungsschicht verfestigt, darauf bildmäßig mit aktinischem Licht belichtet und unter Entfernen der unbelichteten bzw. belichteten Bereiche der Aufzeichnungsschicht, insbesondere mit einem Entwicklerlösungsmittel, entwickelt, dadurch gekennzeichnet, daß man der Oberfläche der endlosen lichtempfindlichen polymeren Aufzeichnungsschicht während der Schichtverfestigung durch Walzenbehandlung eine definierte Oberflächenstruktur gibt.

8. Verfahren nach einem der Ansprüche 1 bis 7, dadurch gekennzeichnet, daß für die Walzenbehandlung eine Walze eingesetzt wird, deren Oberfläche ein Spiegelbild der für die endlose, lichtempfindliche polymere Aufzeichnungsschicht gewünschten Oberflächenstruktur darstellt.

9. Verfahren nach Anspruch 8, dadurch gekennzeichnet, daß die Oberfläche der Walze spiegelglatt ist.

10. Verfahren nach Anspruch 8, dadurch gekennzeichnet, daß die Walzenoberfläche rauh ist, insbesondere mit Rauhtiefen $R_A$ im Bereich von 0,01 bis 10 $\mu$m.

11. Verfahren nach Anspruch 8, dadurch gekennzeichnet, daß der endlosen, lichtempfindlichen polymeren Aufzeichnungsschicht eine linien-, gitter- oder rasterförmige Oberflächenstruktur aufgeprägt wird.